# FASCICULE DE BREVET EUROPEEN

(11) **EP 1 111 778 B1**
(45) Date de publication et mention de la délivrance du brevet: **29.03.2006**
(21) Numéro de dépôt: 99125483.0
(22) Date de dépôt: 21.12.1999
(51) Int. Cl.: H03H 9/10, H03H 9/05

(54) **Résonateur piézo-électrique ultramince**
Piezoelektrischer Dünnfilmresonator
Ultra thin piezo-electrical resonator

(43) Date de publication de la demande: 27.06.2001
(73) Titulaire: ETA SA Manufacture Horlogère Suisse, 2540 Grenchen (CH)
(72) Inventeur: Schulthess, Kurt, 4525 Balm bei Günsberg (CH); Lüthi, Thomas, 2540 Grenchen (CH)
(74) Mandataire: Thérond, Gérard Raymond

(56) Documents cités:
- EP-A- 0 356 266
- WO-A-99/59244
- US-A- 5 260 596

## Description

La présente invention a pour objet un résonateur piézo-électrique ultramince, et plus particulièrement un résonateur de très petites dimensions destiné à être fixé à plat sur le substrat d'un circuit imprimé.

En réduisant les dimensions, l'épaisseur de l'élément piézo-électrique peut être aussi faible que quelques dixièmes de millimètres et doit donc être protégé de toute agression ou contamination extérieure en étant hermétiquement encapsulé dans une enceinte, éventuellement mise sous atmosphère protectrice ou sous vide.

Il est bien évident que cette enceinte doit néanmoins comporter des moyens extérieures de connexion électrique pour les électrodes d'excitation disposées de part et d'autre de l'élément piézo-électrique, ces moyens de connexion formant le plus souvent également les moyens de fixation au substrat.

Les enceintes formées par des ampoules de verre pourvues de tiges de connexion traversantes, les capsules de métal munies de perles de céramique pour les tiges de connexion ou des assemblages de type métal-céramique ayant depuis longtemps été abandonnées, le principe de construction plus récent auquel fait appel la présente invention correspond par exemple au dispositif décrit dans le document US 4,451,754. Ce dispositif comprend une plaquette rectangulaire de matériau piézo-électrique découpée pour former un cadre-support auquel est rattaché l'élément résonant situé au centre, les deux faces étant métallisées pour former à la fois les électrodes d'excitation et au niveau du cadre des moyens de fixation de deux couvercles symétriques conformés pour laisser un espace libre au-dessus de l'élément résonant.

Lorsqu'ils sont réalisés en une seule pièce, les couvercles sont emboutis et présentent chacun une patte de connexion s'étendant parallèlement à la plaquette piézo-éléctrique, de part et d'autre de celle-ci. Lorsqu'ils sont réalisés en deux pièces, chaque couvercle est formé d'un cadre métallique et d'une plaque rectangulaire de fermeture, les pattes de connexion pouvant alors être formées avec les mêmes dispositions que précédemment par des extensions du cadre métallique.

Lorsque le résonateur qui vient d'être brièvement décrit est disposé à plat sur un substrat, on voit que les pattes de connexion sont dans des plans parallèles différents du plan dudit substrat, ce qui a comme inconvénient de ne pas permettre la fixation sur le substrat au moyen de ces seuls pattes de connexion. Or, il est bien connu qu'une part non négligeable de l'énergie de vibration est transmise au substrat, ce qui peut à la longue avoir une influence néfaste sur la qualité et la longévité du résonateur si celui-ci n'est pas conçu avec une fixation efficace et de préférence simple sur le substrat.

La présente invention a pour objet de pallier les inconvénients de l'art antérieur précité en procurant un résonateur ultramince dont les moyens de connexion électriques sont dans un même plan en servant également de moyens de fixation sur le substrat d'un circuit imprimé.

A cet effet, l'invention a pour objet un résonateur piézo-électrique encapsulé comprenant d'une part une plaquette centrale en un matériau piézo-électrique découpée pour former un cadre et un élément résonant central relié audit cadre, les faces supérieure et inférieure ayant un revêtement métallique, d'autre part des couvercles inférieur et supérieur, chacun étant formé par un cadre d'espacement en métal ou en alliage métallique et une plaque de fermeture, caractérisé en ce qu'au moins un des éléments formant les couvercles est relié électriquement au cadre de la plaquette centrale et présente une extension recourbée en Z pour amener sa partie distale en prolongement d'une plaquette de recouvrement et former des moyens de connexion électrique et mécanique situés dans un même plan.

Le mode de réalisation préféré est celui dans lequel toutes les parties constituant les couvercles sont métalliques, la plaque de recouvrement du couvercle supérieur étant alors la seule à présenter une extension recourbée en Z. Selon une variante, la plaque inférieure peut également présenter une extension planaire au-delà de la plaquette centrale et permettre ainsi de rendre plus facile la fixation des pattes de connexion sur un circuit imprimé, par exemple au moyen d'un faisceau laser.

Selon un autre mode de réalisation, les extensions recourbées en Z sont formées à partir d'au moins un cadre d'espacement. Dans le cas où chaque cadre d'espacement est pourvu d'extension en Z, qui seront évidemment à des emplacements différents sur le pourtour du cadre, les plaques de recouvrement supérieur et inférieur pourront alors être formées en un matériau isolant, telle qu'une mince plaquette de verre.

Lorsque les parties extérieures des couvercles sont en métal et doivent être isolées, il est bien sûr possible d'appliquer, selon des techniques connues, un vernis isolant.

D'autres caractéristiques et avantages de l'invention apparaîtront plus clairement à la lecture de la description détaillée des exemples qui suivent, en référence aux dessins annexés dans lesquels:
- la figure 1 est la représentation en perspective d'un résonateur selon l'invention, assemblé et en éclaté, et
- les figures 2 à 6 sont des vues de côté de différents modes de réalisation.

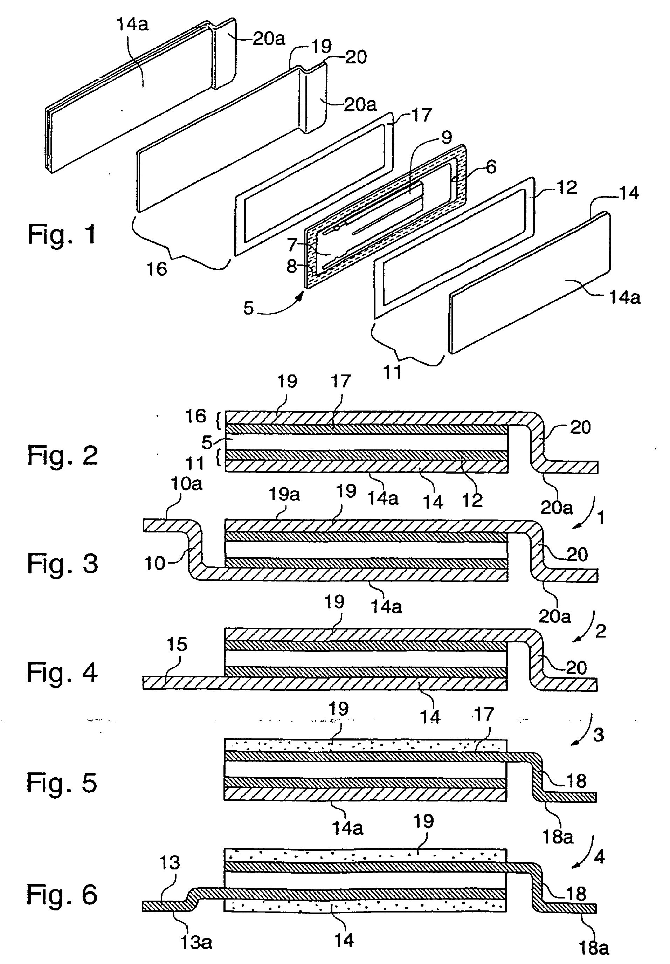

A la figure 1, on a représenté en perspective un résonateur piézo-électrique ultramince 1, décomposé pour une meilleure compréhension en une vue éclatée montrant ses différents éléments constitutifs. La figure 2 représente ce même résonateur en vue de côté. Il comprend de façon connue une plaquette centrale 5 en un matériau piézo-électrique de très petites dimensions. A titre d'exemple, la plaquette a une surface rectangulaire de 5 x 1,8 mm et une épaisseur de 0,15 mm, et elle présente une découpe centrale permettant de former un cadre 6 auquel est rattaché par un de ses petits côtés un élément résonant 9 ici représenté par un diapason. Il est bien évident que l'invention n'est pas limitée à un élément résonant en forme de diapason, et que toute autre configuration d'éléments résonants serait également utilisable dans le cadre de la présente invention. Les faces inférieure et supérieure du cadre 6 et de l'élément résonant 9 ont un revêtement conducteur mince 7, obtenues par des techniques connues, telle que la déposition sous vide. Les surfaces externes 8 (dont une seule est visible sur la figure 1) du cadre 6 constituent les surfaces d'appui et de scellement des autres éléments constitutifs du résonateur. Le couvercle inférieur 11, c'est-à-dire celui qui sera appliqué sur le substrat d'un circuit imprimé est formé de deux parties métalliques : un cadre d'espacement 12 ayant les mêmes dimensions que les surfaces 8 de la plaquette centrale 5 et une plaque de recouvrement 14. Le couvercle supérieur, également formé de deux parties métalliques, comprend un cadre d'espacement 17 identique au cadre 12 et une plaque de recouvrement 19 présentant une extension 20 recourbée en Z. Comme on le voit encore plus clairement en vue de côté à la figure 2, dans laquelle l'épaisseur des éléments assemblés a été fortement exagérée, la première courbure ménage un espace d'isolation électrique avec l'empilage des éléments et l'extrémité de l'extension 20 forme une bride 20a dont la surface inférieure est dans le même plan que la face externe 14a de la plaque de recouvrement inférieure 14. Les surfaces 14a et 20a situées dans un même plan constituent à la fois les moyens de connexion électrique des électrodes et les moyens de fixation sur le substrat d'un circuit imprimé en assurant une très grande stabilité au résonateur ultramince. Selon une variante représentée à la figure 3, on voit que la plaque de recouvrement inférieure 14 présente également une extension recourbée en Z, ladite extension étant antisymétrique de l'extension 20 de la plaque de recouvrement supérieure 19 par rapport au plan médian du résonateur. Cette construction présente l'avantage de procurer des résonateurs dont il ne sera pas nécessaire de discriminer le sens dans une chaîne de montage. La fixation mécanique et électrique sur le substrat d'un circuit imprimé pourra s'effectuer indifféremment par les surfaces 20a, 14a, l'extension 10 étant alors inutilisée, ou par les surfaces 10a, 19a, l'extension 20 n'étant pas utilisée.

L'assemblage des différents éléments qui viennent d'être décrits entre eux est effectué selon les moyens connus de soudage ou de brasage ou en appliquant une colle ou un ciment conducteur.

Selon une variante non représentée, les cadres d'espacement 12, 17 peuvent être réalisé dans un alliage permettant de souder les plaques de recouvrement 14, 19 au cadre tout en ménageant un espace suffisant pour le débattement de l'élément résonant 9. Les cadres 12, 17 sont par exemple découpés dans une mince plaque d'un alliage thermofusible, tel que l'alliage Au-Sn (80/20) par estampage. De façon équivalente, il est possible d'électroformer les cadres 12, 17 avec un tel alliage directement soit sur les plaques de recouvrement 14, 19, soit sur les surfaces 8 du cadre de l'élément piézo-électrique central soit sur les deux en même temps. De même, il est possible d'appliquer un vernis isolant sur toutes les surfaces externes, à l'exception des zones de fixation et connexion.

Selon une variante représentée à la figure 4, la plaque de recouvrement inférieure 14 peut également présenter une extension planaire 15 pouvant rendre plus commode la fixation du résonateur sur le substrat. Selon un autre mode de réalisation représenté à la figure 5, le moyen de connexion de l'électrode d'excitation supérieur est formé par une extension en Z 18 du cadre d'espacement 17, selon les mêmes principes que ceux définis précédemment. Dans ce cas, la plaque de recouvrement 19 a le même contour que le cadre 17 et peut être réalisée en un matériau isolant.

A la figure 6, on a représenté une variante dans laquelle les cadres d'éspacement supérieur 17 et inférieur 12 ont chacun une extension 18 et 13 recourbée en Z. Ce mode de réalisation permet d'avoir également la plaque de recouvrement inférieur 14 en un matériau isolant.

Dans les exemples qui viennent d'être décrits, la ou les extension(s) recourbée(s) Z est(sont) prévue(s) dans !a largeur du résonateur. Il est bien évident que de façon équivalente elles pourraient être réalisées dans tout ou partie de la longueur du résonateur.

## Revendications

1. Résonateur piézo-électrique encapsulé comprenant d'une part une plaquette centrale (5) en un matériau piézo-électrique découpée pour former un cadre (6) et un élément résonant (9) central relié audit cadre (6), les faces supérieure et inférieure ayant un revêtement métallique, d'autre part des couvercles inférieur (11) et supérieur (16), chacun étant formé par un cadre d'espacement (12, 17) en métal ou en alliage métallique et une plaque de fermeture (14, 19), **caractérisé en ce qu'**au moins un des éléments (12, 14, 17, 19) formant les couvercles (11, 16) est relié électriquement au cadre (6) de la plaquette centrale (5) et présente une extension recourbée en Z (10, 13, 18, 20) pour amener sa partie distale (10a, 13a, 18a, 20a) en prolongement d'une plaquette de recouvrement (14, 19) et former des moyens de connexion électrique et mécanique situés dans un même plan.

2. Résonateur selon la revendication 1, **caractérisé en ce que** l'extension recourbée en Z (20) est formée à partir de la plaque de recouvrement supérieure (19).

3. Résonateur selon la revendication 1, **caractérisé en ce que** les plaques de recouvrement supérieure (19) et inférieure (14) présentent chacune une extension recourbée en Z (20, 10) antisymétrique par rapport au plan médian du résonateur.

4. Résonateur selon la revendication 2, **caractérisé en ce que** la plaque de recouvrement (14) du couvercle inférieur (11) présente également une extension planaire (15) au-delà de la plaquette centrale (5).

5. Résonateur selon l'une quelconque des revendications 1 à 4, **caractérisé en ce que** les cadres d'espacement (12, 17) sont réalisés en un matériau thermofusible découpé par estampage d'une feuille ou électroformés sur les plaques de recouvrement (14, 19) ou sur le cadre (6) de la plaquette centrale, ou sur les deux.

6. Résonateur selon la revendication 1, **caractérisé en ce que** l'extension recourbée en Z (13, 18) est formée à partir d'au moins un des cadres d'espacement (12, 17).

7. Résonateur selon la revendication 6, **caractérisé en ce que** les deux cadres d'espacement (12, 17) ont chacun une extension recourbée en Z (13, 18).

8. Résonateur selon la revendication 7, **caractérisé en ce que** les plaques de recouvrement (14, 19) des couvercles inférieur (11) et supérieur (16) sont électriquement isolantes.

## Patentansprüche

1. Eingekapselter piezoelektrischer Resonator, der einerseits ein mittiges Plättchen (5) aus einem piezoelektrischen Material, das so zugeschnitten ist, dass es einen Rahmen (6) und ein mit dem Rahmen (6) verbundenes mittiges Resonanzelement (9) bildet, wobei die obere Fläche und die untere Fläche eine metallische Beschichtung aufweisen, und andererseits einen unteren Deckel (11) und einen oberen Deckel (16), wovon jeder aus einem Abstandsrahmen (12, 17) aus Metall oder aus einer Metalllegierung und aus einer Verschlussplatte (14, 19) gebildet ist, umfasst, **dadurch gekennzeichnet, dass** wenigstens eines der Elemente (12, 14, 17, 19), die die Deckel (11, 16) bilden, mit dem Rahmen (6) des mittigen Plättchens (5) elektrisch verbunden ist und eine Z-förmig gekrümmte Verlängerung (10, 13, 18, 20) aufweist, um seinen distalen Teil (10a, 13a, 18a, 20a) in die Verlängerung eines Abdeckplättchens (14, 19) zu bringen und Mittel für eine elektrische und eine mechanische Verbindung zu bilden, die sich in derselben Ebene befinden.

2. Resonator nach Anspruch 1, **dadurch gekennzeichnet, dass** die Z-förmig gekrümmte Verlängerung (20) ausgehend von der oberen Abdeckplatte (19) gebildet ist.

3. Resonator nach Anspruch 1, **dadurch gekennzeichnet, dass** die obere Abdeckplatte (19) und die untere Abdeckplatte (14) jeweils eine Z-förmig gekrümmte Verlängerung (20, 10) umfassen, die in Bezug auf die Medianebene des Resonators antisymmetrisch sind.

4. Resonator nach Anspruch 2, **dadurch gekennzeichnet, dass** die Abdeckplatte (14) des unteren Deckels (11) ebenfalls eine ebene Verlängerung (15) über das mittige Plättchen (5) hinaus umfasst.

5. Resonator nach einem der Ansprüche 1 bis 4, **dadurch gekennzeichnet, dass** die Abstandsrahmen (12, 17) aus einem wärmeschmelzbaren Werkstoff verwirklicht sind, der durch Stanzen einer Folie zugeschnitten ist, oder auf den Abdeckplatten (14, 19) oder auf dem Rahmen (6) des mittigen Plättchens oder auf beiden durch Elektroformung ausgebildet sind.

6. Resonator nach Anspruch 1, **dadurch gekennzeichnet, dass** die Z-förmig gekrümmte Verlängerung (13, 18) wenigstens anhand eines der Abstandsrahmen (12, 17) gebildet ist.

7. Resonator nach Anspruch 6, **dadurch gekennzeichnet, dass** die zwei Abstandsrahmen (12, 17) jeweils eine Z-förmig gekrümmte Verlängerung (13, 18) besitzen.

8. Resonator nach Anspruch 7, **dadurch gekennzeichnet, dass** die Abdeckplatten (14, 19) des unteren Deckels (11) bzw. des oberen Deckels (16) elektrisch isolierend sind.

## Claims

1. Encapsulated piezoelectric resonator including on the one hand a central plate (5) made of a piezoelectric material cut to form a frame (6) and a central resonant element (9) connected to said frame (6), the top and bottom faces having a metal coating, on the other hand bottom (11) and top (16) covers, each being formed by a spacing frame (12, 17) made of metal or a metal alloy and a closing plate (14, 19), **characterised in that** at least one of the elements (12, 14, 17, 19) forming the covers (11, 16) is electrically connected to the frame (6) of the central plate (5) and has an extension (10, 13, 18, 20) bent into a Z shape to bring its distal portion (10a, 13a, 18a, 20a) in line with a covering plate (14, 19) and to form electrical and mechanical connection means situated in a same plane.

2. Resonator according to claim 1, **characterised in that** the extension bent into a Z (20) is formed from the top covering plate (19).

3. Resonator according to claim 1, **characterised in that** the top (19) and bottom (14) covering plates each have an extension bent into an Z (20, 10) which is asymmetrical with respect to the median plane of the resonator.

4. Resonator according to claim 2, **characterised in that** the covering plate (14) of the bottom cover (11) also has a planar extension (15) beyond the central plate (5).

5. Resonator according to any one of claims 1 to 4, **characterised in that** the spacing frames (12, 17) are made of a hotmelt material cut by stamping a sheet or electroformed on the covering plates (14, 19) or on the frame (6) of the central plate, or on both.

6. Resonator according to claim 1, **characterised in that** the extension bent into a Z (13, 18) is formed from at least one of the spacing frames (12, 17).

7. Resonator according to claim 6, **characterised in that** the two spacing frames (12, 17) each have an extension bent into a Z (13, 18).

8. Resonator according to claim 7, **characterised in that** the covering plates (14, 19) of the bottom (11) and top (16) covers are electrically insulated.
